Europäisches Patentamt

European Patent Office

Office européen des brevets

(11) Numéro de publication: **0 365 418**
**A1**

## (12) DEMANDE DE BREVET EUROPEEN

(21) Numéro de dépôt: 89402859.6

(22) Date de dépôt: 17.10.89

(51) Int. Cl.⁵: **H05K 13/00 , B23K 3/06 , H05K 3/26**

(30) Priorité: 17.10.88 FR 8813659

(43) Date de publication de la demande:
25.04.90 Bulletin 90/17

(84) Etats contractants désignés:
**AT BE CH DE ES GB GR IT LI LU NL SE**

(71) Demandeur: **OSL TECHNOLOGIES**
**12ème Rue 1ère Avenue Z.I.**
**F-06510 Carros(FR)**

(72) Inventeur: **Py, Jean Louis**
**46 Bis Bd Bishoffsheim**
**F-06310 Nice(FR)**

(74) Mandataire: **Clanet, Denis et al**
**Cabinet Beau de Loménie 55, rue**
**d'Amsterdam**
**F-75008 Paris(FR)**

(54) **Convoyeur pour entraînement de cartes de circuits imprimés le long d'un trajet à pentes variables.**

(57) L'invention concerne un convoyeur (10) pour carte de circuits imprimés le long d'un trajet (T) à pentes variables, comportant deux guides latéraux (12, 14) de forme allongée et suivant généralement ledit trajet (T) écartés horizontalement l'un de l'autre de manière à définir entre eux un espace (E) totalement dégagé, aussi bien entre les guides qu'en direction du haut et du bas.

Les guides latéraux comportent d'une part des surfaces verticales (20) continues en vis-à-vis destinées au guidage longitudinal des cartes par glissement de leurs tranches latérales opposées, d'autre part des épaulements inférieurs (22) de faible largeur suivant un profil correspondant au trajet des cartes, sur lesquels les cartes reposent et progressent par glissement de leurs bordures latérales inférieures, et des moyens (36 ; 38 ; 40) destinés à s'opposer au décollement des cartes par rapport aux épaulements inférieurs (22), et le dispositif d'entraînement comprend des organes de poussée (30) engageant la tranche postérieure des cartes.

Fig.1

# Convoyeur pour entraînement de cartes de circuits imprimés le long d'un trajet à pentes variables.

La présente invention concerne un convoyeur pour entraînement de cartes de circuits imprimés le long d'un trajet à pentes variables.

Elle vise, en particulier, un convoyeur spécifiquement conçu pour une machine de nettoyage de cartes de circuits imprimés, telle que l'on trouve habituellement en bout de ligne de production de cartes de circuits imprimés.

Dans les machines de nettoyage les plus courantes, le trajet de cartes suit des tronçons successifs de pentes différentes, un premier tronçon descendant traversant un poste de prélavage par aspersion de solvant, un second tronçon horizontal traversant un bac de lavage rempli de solvant, puis un troisième tronçon ascendant traversant un poste de rinçage final par aspersion de solvant, les deux tronçons descendant et ascendant étant également respectivement précédés et suivis d'un court tronçon horizontal de raccordement à des machines adjacentes.

En raison des changements de pente, les convoyeurs sont habituellement des convoyeurs à tapis grillagé sur lesquels les cartes sont simplement posées, mais ceux-ci présentent un certain nombre de problèmes :
- la miniaturisation des composants devient telle que les cartes sont de plus en plus légères et les jets de solvant qu'elles reçoivent par-dessous dans les postes de pulvérisation ont tendance à les déplacer, voire à les retourner complètement, et l'on doit réduire la puissance des jets inférieurs au profit des jets supérieurs,
- la masse volumique globale de la carte, substrat plus composants, devient inférieure à celle du solvant, de sorte que les cartes ont tendance à flotter dans le bac de lavage ; elles ne sont donc plus correctement entraînées par le convoyeur,
- avec le développement de la technologie des composants montés en surface (CMS), des composants sont de plus en plus souvent montés sur les deux faces de la carte, de sorte que les composants montés sur la face inférieure risquent d'être endommagés par frottement sur les mailles du convoyeur,
- pour un ensemble de fonctions données, la taille des cartes diminue et il convient de réduire corrélativement la taille des mailles du tapis grillagé, pour éviter la chute des cartes au travers des mailles,
- les fils métalliques constituant les mailles du convoyeur n'ont pas un diamètre nul et forment un écran contre les jets de solvant pulvérisé par les rampes de pulvérisation. Etant donné la densité de montage des composants, et compte tenu du fait que certains d'entre eux ont un diamètre inférieur à celui de ces fils métalliques, il risque d'y avoir un mauvais nettoyage,
- les exigences de productivité actuelle imposent que les cartes soient traitées automatiquement d'un bout à l'autre de la chaîne de production sans intervention manuelle et, pour ce faire, les cartes ne doivent subir aucune modification d'orientation à la traversée de la machine de nettoyage,
- la technologie dite des composants montés en surface impose que les cartes soient traitées "telles quelles", c'est-à-dire sans les fixer dans un cadre de manutention. Seules deux bordures latérales des cartes sont laissées libres pour leur transport et leur manutention,
- enfin, les convoyeurs de machines de nettoyage doivent pouvoir entraîner des cartes de largeurs et/ou de longueurs différentes.

Afin de résoudre ces problèmes, la présente invention propose un convoyeur pour cartes de circuits imprimés, le long d'un trajet à pentes variables, comportant deux organes de guidage latéraux et un dispositif d'entraînement des cartes sur toute la longueur desdits guides,
caractérisé en ce que les organes de guidage sont constitués par des guides latéraux de forme allongée et suivant généralement ledit trajet, écartés horizontalement l'un de l'autre de manière à définir entre eux un espace totalement dégagé, aussi bien entre les guides qu'en direction du haut et du bas, les guides latéraux comportant d'une part des surfaces verticales continues en vis-à-vis destinées au guidage longitudinal des cartes, par glissement des tranches latérales opposées des ·cartes, d'autre part des épaulements inférieurs de faible largeur suivant un profil correspondant au trajet des cartes, sur lesquels les cartes reposent et progressent par glissement de leurs bordures latérales inférieures, et des moyens destinés à s'opposer au décollement des cartes par rapport auxdits épaulements inférieurs, et le dispositif d'entraînement comprenant des organes de poussée engageant la tranche postérieure des cartes.

Les détails et avantages de l'invention apparaîtront clairement à la lecture de la description qui va suivre, en se référant aux dessins annexés, dans lesquels :
- la figure 1 est une vue d'ensemble en perspective d'un convoyeur conforme à l'invention, et
- la figure 2 est une vue latérale interne partielle de l'un des guides du convoyeur.

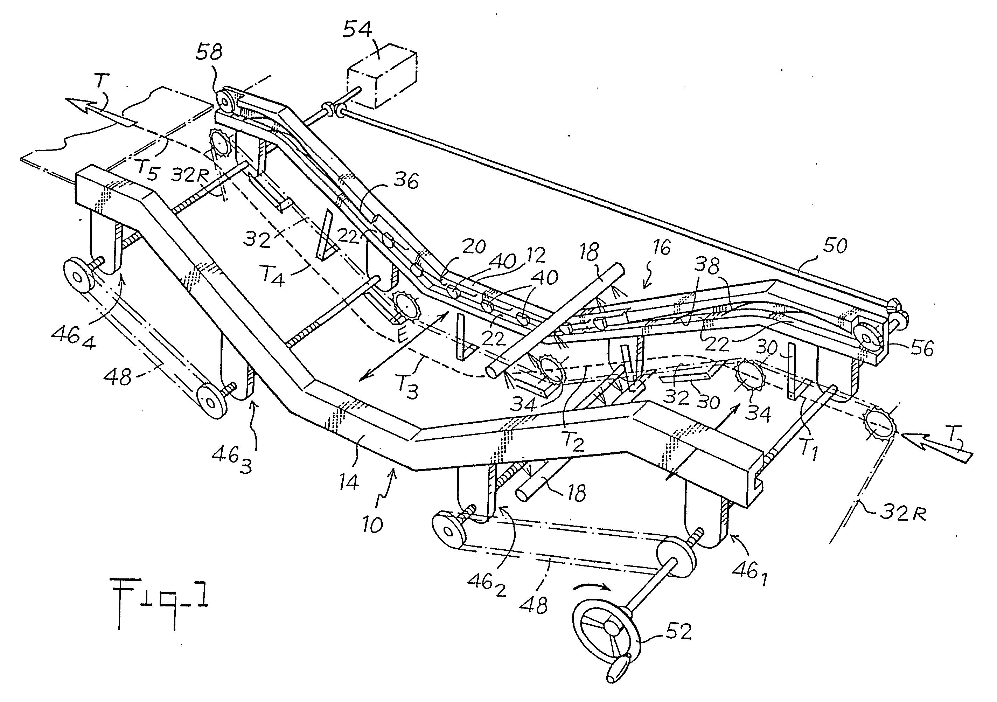

Le convoyeur 10, illustré dans son ensemble à la figure 1, comporte deux guides parallèles 12, 14 ménageant un espace libre E entre eux et dégagé en direction du haut et du bas.

Conçu notamment pour une machine de nettoyage de cartes de circuits imprimés, les guides définissent un trajet T pour les cartes, composé de plusieurs tronçons successifs de pentes différentes.

Le trajet T débute à l'extrémité droite de la figure par un court tronçon $T_1$ sensiblement horizontal que les cartes empruntent en provenance d'une machine non représentée située en amont, typiquement une machine de soudage.

Le trajet T se poursuit par un tronçon descendant $T_2$ le long duquel les cartes traversent un poste de prélavage 16 comportant des rampes 18 de pulvérisation de solvant, représentées schématiquement, situées à la fois au-dessus et au-dessous des cartes.

Le trajet comporte ensuite un tronçon sensiblement horizontal $T_3$ le long duquel les cartes sont immergées dans un bain de solvant, qui n'a pas été figuré pour des raisons de clarté.

Le tronçon suivant $T_4$ est un tronçon ascendant le long duquel les cartes traversent un étage de rinçage final comprenant des rampes de pulvérisation de solvant situées au-dessus et au-dessous des cartes, non représentées également.

Enfin, le trajet se termine par un court tronçon horizontal $T_5$, servant à la sortie des cartes en direction d'une machine placée en aval, typiquement une machine de conditionnement des cartes de circuits imprimés terminées en vue de leur transport, ou encore une machine de contrôle automatique, ou dans certains cas une machine d'application d'un revêtement de protection.

Les cartes de circuits imprimés sont entraînées et guidées telles quelles par le convoyeur, grâce aux dispositions suivantes :
les deux guides 12, 14 comportent des surfaces de guidage verticales 20 en vis-à-vis l'une de l'autre, espacées d'une distance légèrement supérieure à la largeur des cartes, cette distance pouvant être réglée par des moyens qui seront décrits plus loin.

Les cartes sont guidées longitudinalement par glissement de leurs tranches latérales le long des surfaces de guidage des guides.

Les deux guides comportent également des épaulements inférieurs horizontaux 22 de faible largeur, sur lesquels les cartes reposent et progressent par glissement le long des bordures latérales de leur face inférieure.

Aux changements de pente du trajet, les épaulements inférieurs présentent des sections de raccordement, 24, 26.

De préférence, les sections de raccordement sont de profil incurvé 24 afin d'éviter des arêtes vives nuisibles à la progression des cartes et qui risquent d'endommager les bordures des cartes. En fait, les sections de raccordement 26 à profil généralement concave, comme par exemple entre

le tronçon horizontal $T_3$ et les deux tronçons descendant $T_2$ et ascendant $T_4$, pourront suivre un profil à une ou plusieurs facettes de pente intermédiaire, puisque au cours de leur progression, les cartes 28 n'entrent en contact à ce niveau-là avec les épaulements inférieurs 22 que par l'intermédiaire de leurs arêtes inférieures frontale et postérieure.

L'entraînement des cartes, ainsi guidées, s'effectue par des organes de poussée 30 engageant la tranche postérieure des cartes.

Comme illustré, ces organes de poussée sont constitués par des doigts entraînés par une chaine 32 en boucle fermée mue par un moteur non représenté.

La chaîne est montée sur l'un des guides 12 et parcourt un trajet à tronçons successifs analogues à ceux du trajet des cartes, en passant sur une succession de roues dentées 34 situées aux changements de pente.

La chaîne 32 est disposée sensiblement sous le guide 12 afin de ne pas faire écran dans l'espace libre E entre les guides. Les doigts 30 se projettent dans cet espace mais ne constituent pas réellement des écrans, notamment dans les postes de pulvérisation puisqu'ils sont situés en arrière des cartes 28. De plus, ils ont la forme de lames orientées parallèlement au trajet T afin de présenter une section transversale pratiquement négligeable vis-à-vis des jets de solvant pulvérisé.

Les guides 12, 14 comprennent enfin des moyens destinés à s'opposer au décollement des cartes par rapport aux épaulements inférieurs 22.

En effet, il a déjà été exposé qu'un tel décollement pouvait se produire soit dans les postes de pulvérisation sous l'effet des jets inférieurs, soit dans le bain de trempage lorsque la masse volumique de la carte est inférieure à celle du solvant.

Ces moyens peuvent revêtir plusieurs formes de réalisation.

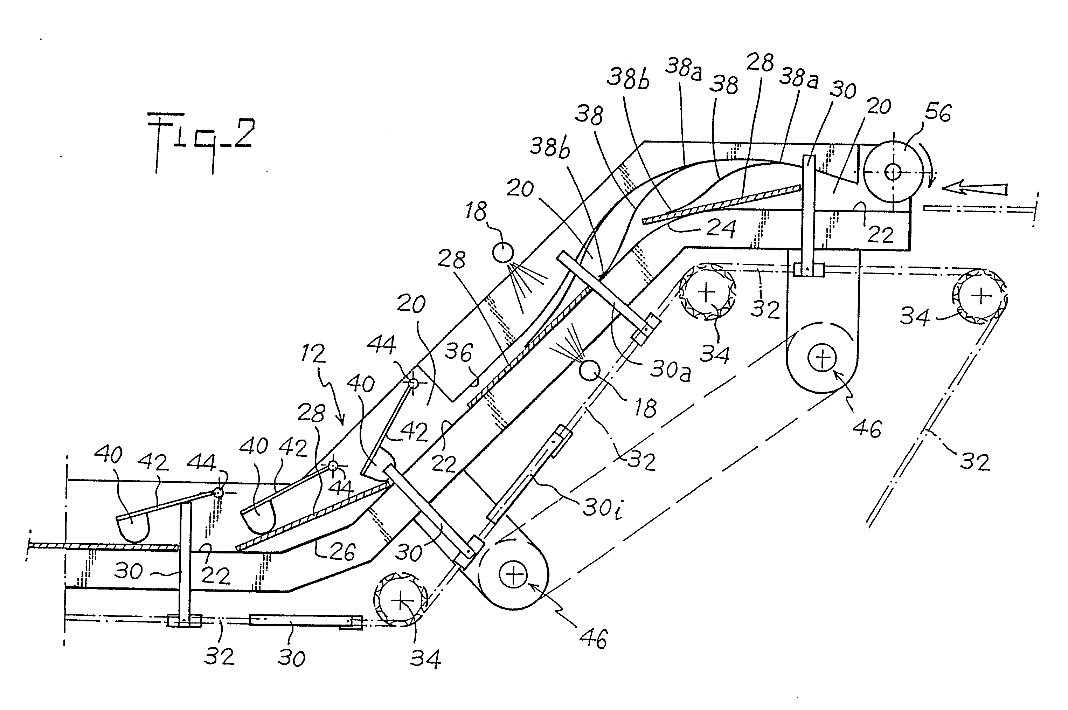

Comme illustré à la figure 2, une première forme de réalisation consiste à prévoir un épaulement supérieur 36, opposé à l'épaulement inférieur 22 et écarté d'une distance légèrement supérieure à l'épaisseur des cartes. Ainsi, en cas de décollement des cartes par rapport aux épaulements inférieurs 22, elles seront retenues par les épaulements supérieurs 36. Cette solution simple et peu coûteuse s'applique, de préférence, aux tronçons de trajet rectilignes d'une certaine longueur. En effet, elle n'est pas applicable aux parties initiales et terminales des tronçons au voisinage des changements de pente puisqu'il faut tenir compte du fait que les cartes s'écartent au moins localement des épaulements inférieurs 22 dans les zones de changement de pente.

En permettant un décollement limité des cartes, cette forme de réalisation permet également un lavage effectif des bordures latérales inférieures des cartes, notamment dans les postes 16 de nettoyage par pulvérisation.

Une seconde forme de réalisation consiste à prévoir des organes 38 appliquant une charge élastique sur les bordures latérales supérieures des cartes. Comme illustré à la figure 2, ces organes peuvent consister en des lames élastiques de faible largeur, fixées à une extrémité 38a au guide 12, 14 au-dessus de l'épaulement inférieur 22 et dont l'autre extrémité 38b vient en contact élastique oblique contre l'épaulement 22, de telle sorte que les cartes 28 en progression soulèvent légèrement les lames élastiques placées successivement le long du guide 12, 14 en recevant de ces lames 38 un effort faible pour ne pas risquer de déformer la carte mais suffisant pour s'opposer au décollement de la carte par rapport à l'épaulement inférieur 22.

Cette forme de réalisation s'applique avantageusement dans les zones de changement de pente où certaines parties de la carte décollent de l'épaulement inférieur, soit à ses extrémités pour ce qui concerne les changements de pente à profil convexe 24, par exemple entre le tronçon initial T1 et le tronçon descendant T2, soit en son centre pour ce qui concerne les changements de pente à profil concave, par exemple entre le tronçon descendant T2 et le tronçon horizontal T3.

La distance de décollement dépend de la longueur des cartes et peut atteindre des valeurs importantes, si bien que les lames élastiques 38 doivent être suffisamment flexibles pour ne pas exercer sur la carte des efforts excessifs qui risqueraient de la déformer et de l'endommager.

Cette forme de réalisation pourra s'appliquer également dans le tronçon descendant T2 où les cartes risquent de glisser, par gravité, plus rapidement que la vitesse d'entraînement de la chaîne 32. Le frottement exercé par les lames 38 sur les cartes 28 aura un effet de ralentissement.

Il est bien entendu prévu que les lames 38 soient suffisamment rapprochées pour que les cartes 28 soient toujours maintenues au cours de leur progression par au moins une lame. Ceci dépend naturellement de la longueur des cartes habituellement traitées dans la machine.

Une troisième forme de réalisation consiste à fixer sur les faces intérieures 20 des guides 12, 14 des lests 40 de faible largeur, fixés au bout d'un bras 42 articulé sur le guide, le lest étant situé en arrière de l'axe 44 par rapport au sens de déplacement des cartes.

En l'absence de carte, le lest repose sur l'épaulement inférieur 22 par une surface arrondie. Lorsqu'une carte progresse, elle soulève le lest 40 qui repose ainsi sur la bordure latérale supérieure de la carte 28 en empêchant que celle-ci ne se décolle de l'épaulement inférieur.

Il est bien entendu prévu que les lests 40 soient suffisamment rapprochés pour que les cartes soient toujours maintenues, au cours de leur progression, par au moins un lest.

L'avantage de ce mode de réalisation, par rapport au précédent, est que le lest 40 applique en toute circonstance une force constante sur la carte 28, quelle que soit la hauteur à laquelle la carte soulève le lest. Ainsi, cette forme de réalisation s'applique de préférence dans les zones de raccordement à profil concave 26, dans lesquelles la partie centrale s'écarte notablement de l'épaulement inférieur 22.

Par comparaison, dans la forme de réalisation précédente, une lame élastique 38 appliquerait un effort croissant avec la distance de décollement par rapport à l'épaulement inférieur 22, ce qui risquerait d'endommager les cartes de grande longueur.

Les deux guides 12, 14 peuvent être écartés ou rapprochés afin de permettre le convoyage de cartes 28 de différentes largeurs.

L'un des guides 12 est monté fixe sur le bâti de machine, non représenté, et le second guide 14 est monté mobile par l'intermédiaire de plusieurs dispositifs 46 à vis et écrou à entraînement synchronisé.

Afin d'assurer que l'écartement entre les guides 12, 14 est constant, bien que ceux-ci ne soient pas linéaires, il est prévu quatre dispositifs 46 de réglage d'écartement à vis et écrou, deux $46_1$, $46_4$ au niveau des tronçons d'entrée T1 et de sortie T5 des guides et deux $46_2$, $46_3$ en partie inférieure de tronçons descendant T2 et ascendant T4.

La synchronisation de l'entraînement est assurée par des renvois à chaîne 48 et/ou des renvois à arbre 50.

Comme illustré, le premier et le second dispositif $46_1$, $46_2$ sont synchronisés par un renvoi à chaîne 48, de même que les troisième $46_3$ et quatrième $46_4$ dispositifs, tandis que le premier $46_1$ et le quatrième $46_4$ sont synchronisés par renvoi à arbre 50.

L'un des dispositifs $48_1$ comprend un organe d'entraînement 52 qui peut être soit manuel, comme illustré, soit motorisé 54.

De son côté, la commande du moteur 54 peut être soit manuelle, soit automatisée, par exemple par programmation sur un clavier de la largeur de carte à passer, ou par lecture d'un code sur une carte se présentant en amont du convoyeur. Naturellement, l'unité de commande comportera toutes les sécurités nécessaires pour éviter la modification de l'écartement tant qu'une carte est présente dans le convoyeur.

Le guide fixe 12 sera bien entendu le guide portant la chaîne d'entraînement 32 des doigts 30 de poussée des cartes.

Les doigts 30 de poussée seront disposés sur la chaîne 32 avec un pas correspondant à la longueur des cartes 28 à faire progresser dans le convoyeur.

En variante, on pourra prévoir de munir la chaîne de doigts 30 faiblement espacés, correspondant à la longueur des cartes les plus courtes à entraîner, ces doigts pouvant être basculés entre une position active 30a dans laquelle ils se projettent entre les deux guides 12, 14 dans le trajet des cartes et sensiblement perpendiculairement à ce trajet, et une position inactive 30i dans laquelle ils sont orientés sensiblement parallèlement à la chaîne 32 et sont situés hors du trajet T des cartes. On pourra ainsi ne mettre en position active qu'un doigt 30 sur deux, sur trois, etc., selon la longueur des cartes à entraîner.

Cette mise en position active 30a, ou inactive 30i, des doigts peut être effectuée manuellement, ou encore automatiquement, par tout moyen approprié comme il apparaîtra à l'homme de métier.

Le convoyeur selon la présente invention pourra être commodément réalisé en "double largeur" afin d'entraîner simultanément des cartes de faible largeur provenant de deux lignes de fabrication.

A cet effet, un second guide réglable en écartement sera disposé de l'autre côté du guide fixe, ce second guide et le guide fixe étant dotés des mêmes surfaces de guidage latérales, épaulements inférieurs et moyens destinés à s'opposer au décollement des cartes que précédemment décrits. Cette variante, à la portée immédiate de l'homme de métier, n'a pas été illustrée.

On mentionnera que le convoyeur comporte une roue d'introduction 56 de cartes sur le tronçon d'entrée T1. Cette roue est fixée sur le guide fixe 12 le long de sa face intérieure 20 et est entraînée à une vitesse tangentielle supérieure à la vitesse de progression de la chaîne 32.

Lorsque les cartes provenant d'une machine située en amont atteignent la roue d'introduction 56, celle-ci les fait progresser suivant le tronçon d'entrée T1, afin de permettre aux doigts de poussée 30 de pivoter librement vers le haut depuis le brin de retour 32R de la chaîne provenant du tronçon de sortie de la machine.

Selon que les cartes entraînées de part et d'autre du guide fixe central auront la même largeur, ou des largeurs différentes, on prévoira que les dispositifs de réglage d'écartement soient communs ou non aux deux guides réglables.

De même, le convoyeur comporte une roue d'extraction 58 des cartes sur le tronçon de sortie T5. Cette roue est fixée sur le guide fixe 12 le long de sa face intérieure 20 et est entraînée à une vitesse tangentielle supérieure à la vitesse de progression de la chaîne 32.

Lorsque les cartes atteignent la roue d'extraction 58, celle-ci les entraîne en direction d'une machine située en aval, ce qui permet aux doigts de poussée de pivoter librement vers le bas sur le brin de retour 52R de la chaîne en direction du tronçon d'entrée du convoyeur.

## Revendications

1. Convoyeur (10) pour cartes de circuits imprimés, le long d'un trajet (T) à pentes variables, comportant deux organes de guidage latéraux (12, 14) et un dispositif d'entraînement (32, 30) des cartes sur toute la longueur desdits guides, caractérisé en ce que les organes de guidage sont constitués par des guides latéraux (12, 14) de forme allongée et suivant généralement ledit trajet (T) écartés horizontalement l'un de l'autre de manière à définir entre eux un espace (E) totalement dégagé, aussi bien entre les guides qu'en direction du haut et du bas, les guides latéraux comportant d'une part des surfaces verticales (20) continues en vis-à-vis destinées au guidage longitudinal des cartes, par glissement des tranches latérales opposées des cartes, d'autre part des épaulements inférieurs (22) de faible largeur suivant un profil correspondant au trajet des cartes, sur lesquels les cartes reposent et progressent par glissement de leurs bordures latérales inférieures, et des moyens (36 ; 38 ; 40) destinés à s'opposer au décollement des cartes par rapport auxdits épaulements inférieurs (22), et le dispositif d'entraînement comprenant des organes de poussée (30) engageant la tranche postérieure des cartes.

2. Convoyeur selon la revendication 1, caractérisé en ce que les épaulements inférieurs (22) comprennent des tronçons successifs horizontaux et inclinés, descendants et/ou ascendants, correspondant à des tronçons successifs du trajet des cartes, et des sections de raccordement (24, 26) à profil courbe ou polygonal, généralement concave ou convexe, entre tronçons de pentes différentes.

3. Convoyeur selon l'une ou l'autre des revendications 1 ou 2, caractérisé en ce que les moyens destinés à s'opposer au décollement des cartes consistent, au moins partiellement, en des épaulements supérieurs (36), ménagés sur chaque guide (12, 14) en vis-à-vis des épaulements inférieurs (22) et distants de ceux-ci d'une distance légèrement supérieure à l'épaisseur des cartes.

4. Convoyeur selon l'une ou l'autre des revendications 1 ou 2, caractérisé en ce que les moyens destinés à s'opposer au décollement des cartes consistent, au moins partiellement, en des lames élastiques (38) faible largeur fixées à une extrémité aux guides latéraux (12, 14) et reposant obliquement et élastiquement à leur autre extrémité sur les épaulements inférieurs (22), les cartes restant appliquées sur ces derniers par lesdites lames (38)) au cours de leur progression.

5. Convoyeur selon l'une ou l'autre des revendications 1 ou 2, caractérisé en ce que les moyens destinés à s'opposer au décollement des cartes consistent, au moins partiellement, en des lests (40) de faible largeur fixés à l'extrémité de bras (42) articulés (46) sur les guides (12, 14) et reposant sous leur propre poids sur les épaulements inférieurs (22) de guides, les cartes restant appliquées sur ces derniers par lesdits lests (40) au cours de leur progression.

6. Convoyeur selon l'une quelconque des revendications 1 à 5, caractérisé en ce que le dispositif d'entraînement comprend une chaîne (32) sans fin passant sous l'un des guides (12) et portant à intervalles réguliers des doigts de poussée (30) se projetant vers l'espace (E) situé entre les guides.

7. Convoyeur selon la revendication 6, caractérisé en ce que les doigts de poussée (30) sont mobiles entre une position active, (30a) dans laquelle les doigts font saillie dans le trajet (T) des cartes, et une position inactive (30i), dans laquelle les doigts sont situés hors du trajet (T) des cartes.

8. Convoyeur selon l'une quelconque des revendications 1 à 7, caractérisé en ce que l'un des guides (12) est monté fixe sur un bâti de machine, et l'autre guide (14) est monté à écartement horizontal réglable par rapport au guide fixe.

9. Convoyeur selon la revendication 8, caractérisé en ce que le réglage d'écartement entre les guides est assuré au moyen de plusieurs dispositifs (46) à vis et écrou synchronisés.

10. Convoyeur selon la revendication 9, caractérisé en ce que les dispositifs de réglage d'écartement à vis et écrou sont commandés manuellement (52).

11. Convoyeur selon la revendication 9, caractérisé en ce que les dispositifs de réglage d'écartement à vis et écrou sont commandés par moteur (54)

12. Convoyeur selon l'une quelconque des revendications 8 à 11, caractérisé en ce qu'il comprend un second guide monté à écartement horizontal réglable par rapport au guide fixe, du côté opposé au premier guide monté à écartement horizontal réglable.

13. Convoyeur selon l'une quelconque des revendications 8 à 12, prise en combinaison avec la revendication 6, caractérisé en ce que le guide fixe (12) est celui qui porte la chaîne (32) du dispositif d'entraînement.

14. Convoyeur selon l'une quelconque des revendications 1 à 12, caractérisé en ce qu'il comporte des roues d'introduction (56) et d'extraction (58) des cartes aux extrémites de l'un des guides, entraînées à une vitesse tangentielle supérieure à celle du dispositif d'entraînement.

Fig-1

Fig. 2

EP 0 365 418 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | DE-A-3318614 (EHMANN)<br>* page 8, lignes 19 - 27; revendications 1-8; figures 1-3 *<br>--- | 1, 2, 8 | H05K13/00<br>B23K3/06<br>H05K3/26 |
| A | EP-A-204609 (OUTILLAGES SCIENTIFIQUES ET DE LABORATOIRES O.S.L.)<br>* colonne 3, lignes 4 - 44; figure 1 *<br>--- | 1, 2 | |
| A | DE-C-3328091 (KNOLLMANN)<br>* colonne 4, lignes 27 - 34; figures 1, 2 *<br>----- | 1, 2 | |

|  |
|---|
| **DOMAINES TECHNIQUES RECHERCHES (Int. Cl.5 )** |
| H05K<br>B23K |

**Le présent rapport a été établi pour toutes les revendications**

| Lieu de la recherche | Date d'achèvement de la recherche | Examinateur |
|---|---|---|
| LA HAYE | 18 JANVIER 1990 | RIEUTORT A.S. |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................
& : membre de la même famille, document correspondant